# NEUE EUROPÄISCHE PATENTSCHRIFT

(11) **EP 0 445 651 B2**
(45) Veröffentlichungstag und Bekanntmachung des Hinweises auf die Entscheidung über den Einspruch: **17.12.2003**
(45) Hinweis auf die Patenterteilung: 10.07.1996
(21) Anmeldenummer: 91102968.4
(22) Anmeldetag: 27.02.1991
(51) Int. Cl.: H01L 21/00

(54) **Vorrichtung zum Halten und Transportieren von plattenförmigen Substraten**
Device to hold and transport plate-shaped substrates
Dispositif pour tenir et transporter des substrats de forme plate

(30) Priorität: 05.03.1990 CH 68690
(43) Veröffentlichungstag der Anmeldung: 11.09.1991
(73) Patentinhaber: TENCOR INSTRUMENTS, Mountain View, CA 94043 (US)
(72) Erfinder: Malin, Cosmas, FL-9493 Mauren (LI); Sawatzki, Harry, FL-9490 Vaduz (LI)
(74) Vertreter: Fiener, Josef

(56) Entgegenhaltungen:
- EP-A- 0 339 560
- JP-A- 615 519
- JP-A- 6 263 075
- JP-A- 61 005 519
- JP-A- 62 063 075
- JP-A- 62 213 983
- JP-A- 62 293 631
- JP-A- 63 300 525
- US-A- 4 410 209
- US-A- 4 639 028
- US-A- 4 900 214

## Beschreibung

Die Erfindung betrifft eine Vorrichtung zum Halten und/oder Transportieren von plattenförmigen Substraten, gemäß den oberbegrifflichen Merkmalen des Patentanspruches 1.

Derartige Substrate bzw. Wafer sind bei einer vorzunehmenden Bearbeitung und/oder Inspektion in aller Regel aus einer sogenannten Waferkassette auszulagern, auf einer Auflage eines Bearbeitungs- und/oder Inspektionstisches zwischenzulagem und nach entsprechender Bearbeitung und/oder Inspektion in einer weiteren Waferkassette endzulagern.

Die zu bearbeitenden und/oder zu inspizierenden Wafer befinden sich während des Bearbeitungs- und/ oder Inspektionsvorgangs in einer speziellen Atmosphäre, um jegliche Art von Verschmutzung verhindern zu können, und ferner ist auch beim Transport zu verhindern, dass sich die einmal im Transportsystem eingenommene Lage verändert.

Das US-Patent 4,410,209 beschreibt ein manuelles, zangenartiges Werkzeug zum Halten und Transportieren von Waferscheiben. Dieses Handwerkzeug umfaßt einen federbeaufschlagten Kolben und eine gegenüberliegende Spitze, mit der über einen Zugdraht die Waferscheibe an ein stationäres Tragelement mit einer Umfangsrille gespannt wird.

Neue Submikrometrie-Technologien verlangen nicht nur absolut kontaminationsfreie Vorderseiten von Substraten und Wafern sondern auch partikelfreie Rückseiten.

Beispielsweise können bereits Waferrückseiten-Kontaminationen zur Defokusierung einer mikrolithographischen Belichtung führen. So gilt es beispielsweise als Standardanforderung an viele Substrate, wie z. B. Glassubstrate für Masken, beidseitig absolut kontaminationsfrei sein zu müssen.

Zudem ist ein sicheres und zuverlässiges automatisches Erfassen des Substrats bzw. des Wafers durch den entsprechenden Greifer unbedingtes Erfordernis einer mit hoher Geschwindigkeit arbeitenden Waferbearbeitung- und/oder Inspektions-Einrichtung.

Eine erste Möglichkeit einer solcher Greiferanordnung besteht darin, dass ein Greifer mit einem Aufnahmevorrichtung versehen wird, die eine Vakuumeinrichtung enthält, wobei über Saugöffnungen die zu inspizierenden Wafer über einen Teil der plattenförmigen Oberfläche an die Aufnahmevorrichtung angesogen werden und so transportierbar sind (DE-OS 39 17 260)

Bei der dabei beschriebenen Anordnung wird also der Wafer wenigstens teilweise auf einer seiner empfindlichsten Oberflächen angesogen und damit wird eine Kontamination dort nicht verhinderbar. Zudem sind solche Wafer oder Substrate äusserst dünne Scheiben und nicht aus sehr biegestabilem Material. Durch die einseitige Belastung, die also beim so eingespannten Wafer bei Schwenkbewegungen beispielsweise erfolgt, wird ein gelegentlicher Bruch während der Handhabung in Kauf genommen. Dies ist bei derartigen Systemen ein nicht zu akzeptierender Nachteil.

Ein weiterer nicht zu verachtender Nachteil bei solchen unter Vakuum angesogenen Substraten ist die Tatsache, dass bei Ausfall des Vakuums, das Substrat von der Einspannstelle abfällt und beschädigbar wird, was übrigens auch der Fall ist, wenn bei solch einseitig angesogenen Substraten bei Schwenkbewegungen des Greifers unbeabsichtigt oder durch seitliches Verrutschen -also ungenaues Positionieren- eine Löschung des Vakuums erfolgt.

Eine zweite Möglichkeit die Greiferanordnung über zwei flexibel geführte Tragelemente zu realisieren (DE-OS 34 02 664) ist schon rein von der Art der auszuführenden Bewegungen nicht akzeptabel. Die Verwendung von Riementrieben, wie dabei vorgeschlagen, ergibt bei Bewegungen grosse Verschmutzungsgefahr und Instabilität sowie Schwankungen, dass Systemschwingungen eine unmittelbare Folge wären.

Das US-Patent 4,900,214 beschreibt ein Handlingsystem, bei dem ein Greifarm über Tragelemente einen Wafer am Rande erfaßt. Die Tragelemente sind dabei senkrecht zur Längserstreckung eines länglichen Verbindungsteils nach unten abstehend angeordnet. Hierdurch muß zum Eintauchen des länglichen Verbindungsteils über dem in einer Waferkassette abgelegten Substrat genügend Platz vorhanden sein. So werden in dieser Druckschrift bestimmte Mindesthöhen der Ablagefächer der Waferkassette in Abhängigkeit von der Höhe des nach unten abstehenden Tragelementes definiert. Dies gilt auch für eine Vorrichtung gemäß der JP-A-62-293 631. Hier bei wird ein Klemmpin an einem zungenartigen Piezoelement gelagert und dieses kann zum Wafer hin bewegt bzw. abgebogen werden.

Im übrigen verbleibt auch gerade bei der oben beschriebenen Anordnung als weiterer Nachteil bezüglich des Erkennens eines zu greifenden Wafers, dass dieses Erkennen nur so gut gesichert ist, als das dem Robotersystem zu Beginn der Inspektion übermittelte Koordinatensystem stabil gehalten werden kann. Wenn auch Vorkehrungen getroffen sind die Inspektionseinrichtung vibrations- und schwingungsisoliert zu lagern, so kann die derart erzielbare Genauigkeit und Zuverlässigkeit nicht als ausreichend betrachtet werden.

Es muss vielmehr dafür gesorgt werden, dass bei derartigen Handlingssystemen vor dem Erfassen eines zu transportieren bzw. zu bearbeitenden Wafers jeweils die Bewegung nach emeuter Justierung gesteuert vorgenommen werden kann, dies insbesondere auch daher, weil sich die Wafer im Aufbewahrungszustand in aller Regel in Standard-Kassetten befinden. die nur einen sehr geringen Abstand zwischen zwei sich benachbart liegenden Wafern vorsehen.

Nicht zuletzt sollte das System erkennen können, ob ein Wafer zur Inspektion vorhanden ist oder nicht. Für ein berührungsloses Erkennen von Gegenständen über grössere Distanzen haben sich dazu u.a. optische Systeme durchgesetzt und zwar, die beiden folgenden Varianten: Sender und Empfänger einer Lichtquelle sind so angeordnet, dass der zu erkennende Gegenstand zwischen Sender und Empfänger zu liegen kommt, oder aber das via Gegenstand vom Sender reflektierte oder gestreute Licht wird von einem Empfänger detektiert.

Systeme der ersten Art arbeiten meist sehr zuverlässig, haben aber den Nachteil, dass Sender und Empfänger konstruktiv räumlich von einander getrennt sein müssen, was damit eine kompakte Bauweise verunmöglicht. Systeme derzweiten Art sind unzuverlässiger, weil Beschaffenheit und Geometrie der Oberfläche einen grossen Einfluss ausüben. Hingegen lassen sie eine Bewegung des Senders zu, was oft von Vorteil ist.

Es ist somit Aufgabe der vorliegenden Erfindung, eine Vorrichtung der eingangs erwähnten Art zu schaffen, mittels welchen sich ein Substrat, insbesondere ein Wafer zuverlässig und schonend auf kleinstem Raum Zwischenlagern, erfassen und transportieren lässt.

Zur Lösung dieser Aufgabe wird eine Vorrichtung gemäß Patentanspruch 1 vorgeschlagen.

Es ist vorteilhaft, dass ein Sender und Empfanger einer optischen Detektionseinrichtung auf dem Greifer angeordnet werden und der durch den Sender ausgesendete Lichtstrahl so fokusiert wird, dass der Fokuspunkt des ausgesandten Lichtstrahls auf dem Rand eines zu detektierenden Substrates zu liegen kommt.

In einer Weiterentwicklung der Erfindung wird der Fokuspunkt des ausgesandten Lichtstrahls auf die Randkante des zu detektierenden Wafers ausgerichtet, was dazu führt, dass eine äusserst präzise automatische Steuerung des Greifers realisiert werden kann.

Die Erfindung baut also auf der Grundidee auf, den zu haltenden und zu transportierenden Wafer ausschliesslich an seinem äusseren Rand zu fassen und dadurch jede Kontamination der hochwertigen Waferoberfläche zu vermeiden. Zudem wird durch die federnde Einspannung verhindert, dass Spannungen durch zu hartes mechanisches Belasten des äusseren Randes erzeugt werden könnten und die zum Bruch einer Waferscheibe führen könnten, vermieden werden. Durch die kombinierte Anordnung von Sender und Empfänger der optischen Detektionseinrichtung auf ein und demselben Bauteil, nämlich dem Greifer, wird eine äusserst platzsparende Anordnung vorgestellt.

In einer weiteren Ausgestaltung der Erfindung ist zwischen Sender und Empfänger der optischen Detektionseinrichtung eine spiegelnde Fläche so angeordnet, dass der reflektierte Lichtstrahl direkt durch eine Blende in einem Empfänger gespiegelt wird. Wird dann im Fokuspunkt des Lichtstrahls ein Gegenstand -beispielsweise eine Randkante eines Wafers- eingebracht, so wird der Lichtstrahl unterbrochen. Da der Durchmesser im Fokuspunkt sehr klein sein kann, ist die Aenderung des am Empfänger eintreffenden Lichtes schon bei sehr kleinen bzw. dünnen Gegenständen bzw. bereits bei kleinen Verfahrwegen sehr gross. Somit kann wegen dieses kleinen Fokuspunktes also die Randkante der Waferscheibe sehr genau detektiert werden.

Bei der unerheblichen Beweglichkeit der optischen Detektionseinrichtung spielt natürlich eine ausschlaggebende Rolle, dass die reflektierende Oberfläche eine der Bewegungsfläche entsprechend grosse Abmessung aufweist.

Weitere vorteilhafte Ausgestaltungen der Erfindung bilden den Gegenstand der abhängigen Ansprüche.

Ein Ausführungsbeispiel der Erfindung wird im folgenden unter Bezugnahme auf die Zeichnungen näher beschrieben. Es zeigen:
- Fig. 1: eine Gesamtdarstellung der Wafer-Inspektionseinrichtung;
- Fig. 2a: eine Detaildarstellung aus Fig. 1 mit dem Handlingsystem in Vorbereitungsstellung
- 2b: eine Detaildarstellung aus Fig. 1 mit dem Handlingsystem in Arbeitsstellung;
- Fig. 3: eine Darstellung eines Greifers mit einer erfindungsgemässen Vorrichtung
- Fig. 4: eine Darstellung eines weiteren Greifers

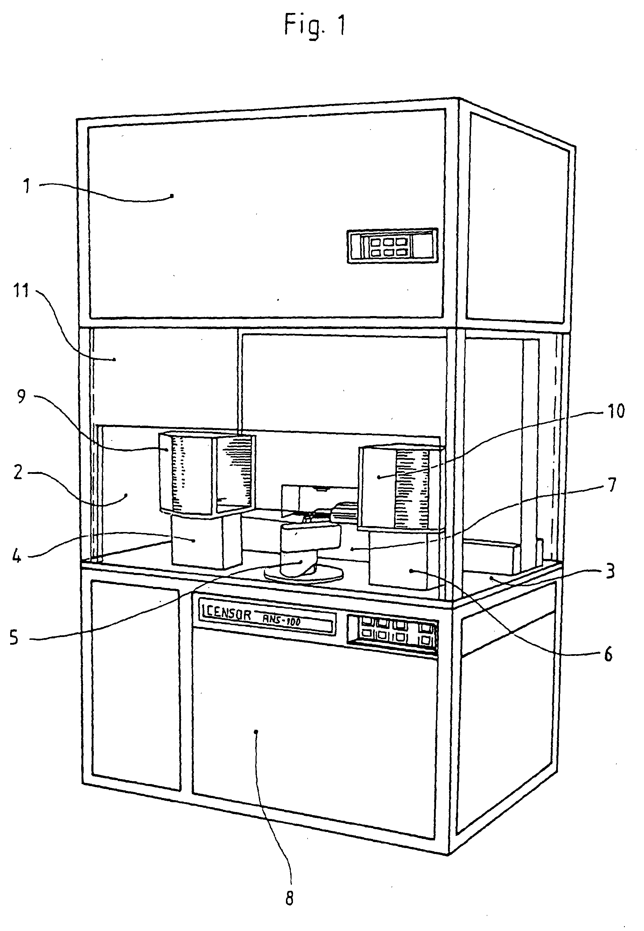

**Fig. 1** zeigt ein Substrat-Oberflächen-Inspektionsgerät, wie es hauptsächlich zur Inspektion von Wafers zur Anwendung kommt. Neben kleinsten Partikeln können mit solchen Einrichtungen Kristallfehler, metallische Verunreinigungen, Polierfehler, Kratzer, Implantationsinhomogenitäten und andere Effekte an Wafern visualisiert werden.
Das Gerät weist eine Flow-Box 1 auf, die für die notwendige Reinheit der Atmosphäre im Messraum 2 sorgt. Der Messraum 2 wiederum ist durch antistatische, durchsichtige Kunststoffplatten 11 ummantelt. Dadurch wird der erwünschte Laminar-Flow durch einen Kamineffekt erzielt.

Das Handlingsystem ist auf einer aerodynamisch transparenten Tischplatte 3 befestigt. Zudem besitzt dieses Inspektionsgerät eine erste Substratkassetten-Aufnahme 4, einen Roboter 5 und eine zweite Substratkassetten-Aufnahme 6. Der Inspektionsvorgang wird auf einem Messtisch 7 ausgeführt.

Das Handlingssystem ist auf einem ebenfalls strömungs-transparenten Gestell 8 aufgebaut.
Ein üblicher Messablauf ist der folgende:
Ein Substrat wird aus einer ersten Substratkassette 9, die sich auf der Substratkassetten-Aufnahme 4 befindet, mittels dem Roboterarm entnommen und auf den Messtisch 7, wo der eigentliche Inspektionsvorgang durchgeführt wird, transportiert.
Nach der Messung entnimmt der Roboter 5 das Substrat und gibt es in die auf der zweiten Substratkassetten-Aufnahme 6 vorgesehenen zweiten Kassette 10. Von besonderer Bedeutung ist dabei, dass sich das Substrat weder während des Transportes noch während der Lagerung zwecks Inspektion mit grossem Abstand über der Tischplatte 3 befindet.

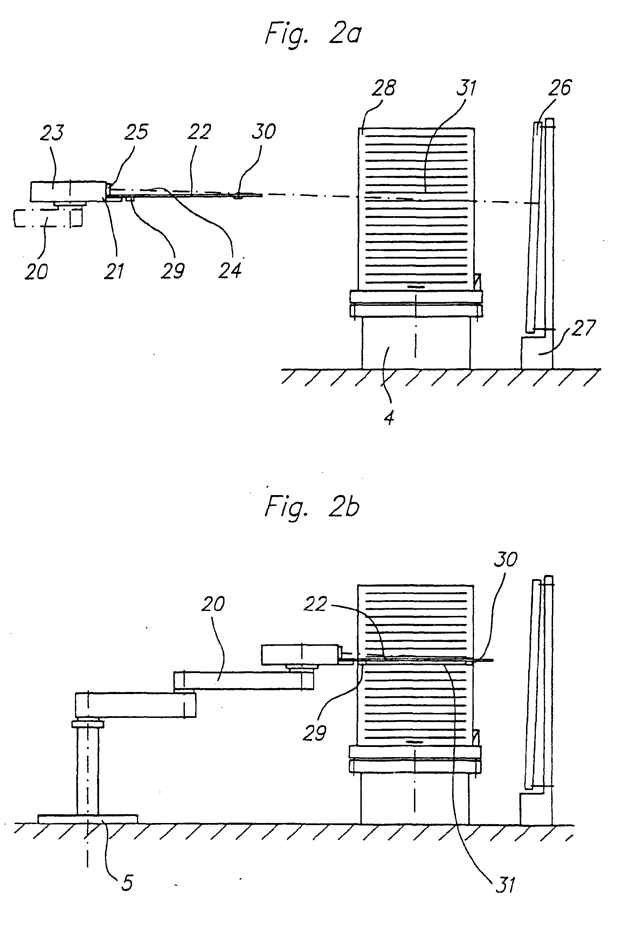

**Fig. 2a** zeigt eine Detaildarstellung aus der Wafer-Inspektions-Vorrichtung. Auf einem Roboterarm 20 des Roboters 5 ist eine Greifervorrichtung 21 -bestehend aus Greifer 22 und Greiferantrieb 23- im Ruhezustand, also in der Vorarbeitsstellung dargestellt. Ein Laserstrahl 24 eines Substraterkennungssystems 25 ist auf einen über eine Spiegelhalterung 27 justierbaren Spiegel 26 gerichtet. Der Spiegel 26 ist so eingestellt, dass der Laserstrahl 24 in das Substraterkennungssystem 25 zurück reflektiert wird.
Zwischen Substraterkennungssystem 25 und Spiegel 26 befindet sich dabei die erste Waferkassette 28. Durch diese Waferkassette 28 kann der Laserstrahl 24 ungehindert vom Substraterkennungssystem 25 auf den Spiegel 26 und wieder zurück gelangen. Bei Vorhandensein eines Wafers 31 in der Waferkassette 28 gelangt der Laserstrahl 24 nicht mehr in das Substraterkennungssystem zurück. Unter diesen Voraussetzungen ist ein Klemmpinn 30 des Greifers 22 hochgeklappt und damit ist der Greifer in der Lage zwischen zwei benachbarten Wafern in die Waferkassette einzutauchen, bis er exakt über einer Wafer-Oberfläche steht.

**Fig. 2b** zeigt den Roboterarm 20 des Roboters 5 im ausgefahrenen Zustand, in der Arbeitsstellung, beim Greifen eines Wafers 31 aus der mit Wafern gefüllten Waferkassette 28. Der Wafer 31 wird dabei zwischen dem in die Greifposition gedrehten Klemmpinn 30 und einem Tragelement 29 eingespannt. In dieser Stellung wird dann der Wafer 31 durch die Federspannkraft einer Waferklemmfeder 32 des Greiferantriebs 23 gehalten. Zur Entnahme hebt der Roboter 5 den Wafer 31 leicht an, bevor der Roboterarm 20 zurückgezogen wird.

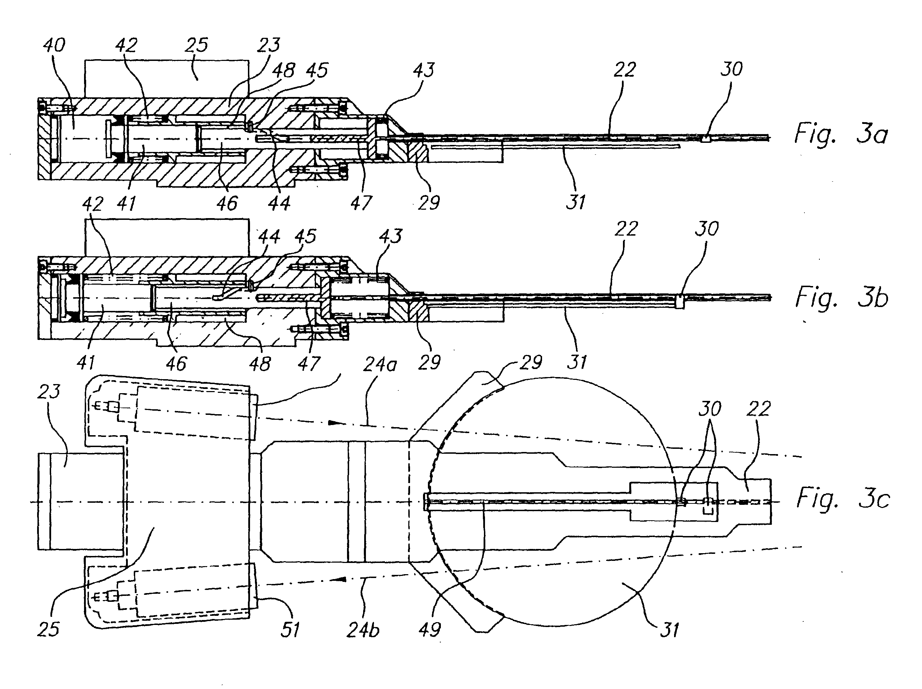

**Fig. 3a** zeigt die Seitenansicht eines Ausführungsbeispiels im offenen -nicht klemmenden- Zustand. In diesem Zustand ist ein Ueberdruck in einer Druckkammer 40 vorhanden, der einen Zylinderkolben 41 und einen Nutkolben 46 gegen die Federkraft einer Zylinderkolbenfeder 42 eine Nutkolbenfeder 48 und eine Waferklemmfeder 43 in Richtung der Gabel 22 verschiebt. Der Zylinderkolben 41 und der Nutkolben 46 sind von einander unabhängig bewegbar. Vom Nutkolben 46 wird bei der Längsbewegung eine durch eine Nut 44 und einen Nutstift 45 definierte Drehbewegung ausgeführt. Dabei überträgt der Nutkolben 46 diese Bewegung an einen Nutkolbenmitnehmer 47, der seinerseits starr mit einer Zug-/Druckstange 49 und dem Klemmpinn 30 verbunden ist.

**Fig. 3b** zeigt die Seitenansicht des Ausführungsbeispiels im geladenen Zustand. In der Druckkammer 40 herrscht dabei kein Ueberdruck. Die Zylinderkolbenfeder 42 drückt den Zylinderkolben in die Ruhestellung. Der Nutkolben 46 wird durch die Nutkolbenfeder 48 zurück gefahren und dabei der Nut 44 entlang gedreht. Die Verbindung zwischen Nutkolben 46 und Nutkolbenmitnehmer 47 ist so ausgeführt, dass der Nutkolbenmitnehmer 47 die Längsbewegung des Nutkolbens 46 nur soweit vollzieht, als dies von dem durch den Klemmpinn 30 und die Zug-/Druckstange 49 geklemmten Wafers 31 zulässt. Der Nutkolbenmitnehmer 47 hebt vom Nutkolben 46 ab, und die Wafer-Klemmfeder 43 presst über die Zug-Druckstange 49 den Klemmpinn 30 gegen den Wafer 31 und somit den Wafer 31 gegen das Tragelement 29.

**Fig. 3c** zeigt eine Draufsicht des Ausführungsbeispiels. Dabei ist besonders die Lage des Wafers 31 und die durch den Klemmpinn 30 eingenommene Lage -im geklemmten Zustand- sichtbar. Auf dem Greifarm ist dabei auch eine Laser-(Sende-)Lichtquelle 50 und ein entsprechender Empfänger 51 angedeutet. Dabei wird der von der Lichtquelle 50 ausgesandte Strahl 24 über einen Hinweg 24a zum Spiegel 26 geleitet und über einen Rückweg 24b reflektiert.

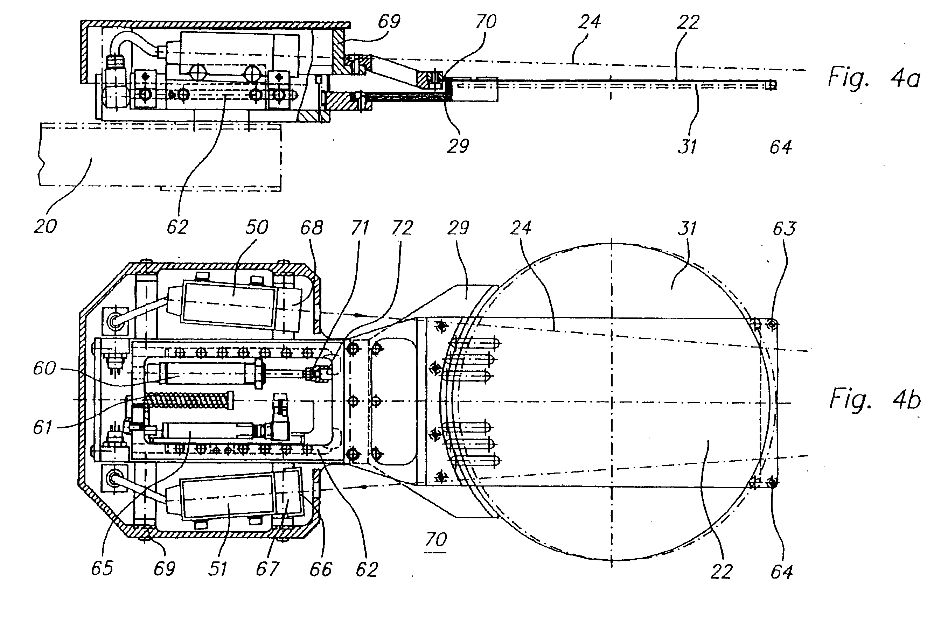

**Fig. 4a** zeigt eine Seitenansicht eines Beispiels in dem ein Pneumatikzylinder 60 ein auf einer Linearfuhrung 62 gelagerter Schlitten 69 verschiebt. Die Verbindung zwischen Pneumatikzylinder-Betätigungsstange 71 und dem Schlitten 69 ist lose über ein Dämpfungselement 72 gekoppelt.
Der Schlitten 69 wird mittels einer Feder 61 gegen die Pneumatikzylinder-Betätigungsstange 71 gepresst. Die Gabel 22 ist starr mit dem Schlitten 69 gekoppelt. Im geöffneten Zustand herrscht ein Ueberdruck im Pneumatikzylinder 60, der somit die an der Gabel 22 befestigten Klemmpins 63 und 64 vom Tragelement 29 wegbewegt. Bei Abfall des Ueberdruckes im Pneumatikzylinder 60 wird der Schlitten 69 mit der Gabel 22 und den Klemmpins 63 und 64 durch die Feder 61 soweit in Richtung X des Tragelements 29 bewegt, bis der Wafer 31 auf den Klemmpins 70 des Tragelements 29 aufliegt.

**Fig. 4b** zeigt eine Draufsicht des vorgenannten Beispiels. Dabei ist ein Schalter 65 vorgesehen, der auf die Position eines Schlittens 69 bezüglich dem Rotorarm 20 anspricht. Die Laserlichtquelle 50 weist eine Optik 68 auf, die den Lichtstrahl 24 auf die Position des zu erkennenden Wafers 31 im zurückgefahrenen Zustand des Roboterarms 20 fokusiert. Ein Emplänger 51 weist eine Optik 67 mit nicht dargestellten Linsen und Filtern. der eine Blende 66 vorgeschaltet ist, auf. Diese Komponenten erhöhen die Zuverlässigkeit und Genauigkeit des Substraterkennungssystems.

## Patentansprüche

1. Vorrichtung zum Halten und/oder zum Transportieren von plattenförmigen Substraten, insbesondere Wafern, mittels Handlingsystemen in Substrat-Bearbeitungs- und/oder Inspektions-Einrichtungen, insbesondere in Wafer-Inspektionseinrichtungen wobei ein beweglicher Arm (20) des Handlingsystems (5) mit einer Greifvorrichtung (21) versehen ist, sowie das zu haltende bzw. zu transportierende Substrat (31) zwischen wenigstens zwei in der Ebene des Substrats (31) sich gegenüberliegende Tragelemente (29, 30) eingespannt wird, wobei wenigstens eines der Tragelemente (29) ortsfest angeordnet und wenigstens ein weiteres verschiebbar ausgebildetes Tragelement (30) tangential an den Rand des zu transportierenden Substrats anlegbar ist, sowie die beiden Tragelemente (29, 30) über mindestens ein längliches Verbindungsteil (22) miteinander verbunden sind, wobei die Tragelemente (29. 30) in Greifposition senkrecht zur Längserstreckung des länglichen Verbindungsteils (22) abstehend angeordnet sind,
**dadurch gekennzeichnet, daß**
im länglichen Verbindungsteil (22) parallel zu dessen Längserstreckung eine Drehführung (44/45) vorgesehen ist, wobei das verschiebbare Tragelement (30) von einer Ruhelage in die Greifposition verdrehbar ist und federnd gegen das Substrat (31) abstützbar ausgebildet ist.

2. Vorrichtung nach Anspruch 1,
**dadurch gekennzeichnet, daß**
wenigstens eines der Tragelemente (29, 30) sich mehrfach auf Anlagepunkte (63,64) gegen den Rand des zu transportierenden Substrats (31) abstützt.

3. Vorrichtung nach Anspruch 1 oder 2,
**dadurch gekennzeichnet, daß**
die Drehführung (44/45) über eine erste Kolben-/Zylinder-Anordnung (41) betätigbar ist, bei welcher ein Kolben (46) eine schräg zur Längsachse verlaufende Schlitznut (44) aufweist, in welcher ein Umlenkstift (45) angeordnet ist, wobei der Kolben (46) in Richtung zum verschiebbaren Tragelement (30) gegen die Kraft einer Nutfeder (43) verschiebbar ist.

4. Vorrichtung nach Anspruch 3,
**dadurch gekennzeichnet, daß**
die erste Kolben-/Zylinder-Anordnung (41) mit einer zweiten Zylinder-/Kolben-Anordnung (60) in Verbindung steht, die gegen die Kraft einer Klemmfeder (61) verschiebbar ist.

5. Vorrichtung nach Anspruch 4,
**dadurch gekennzeichnet, daß**
die erste Kolben-/Zylinder-Anordnung (41) mit der zweiten Kolben-/Zylinder-Anordnung (60) eine Einheit bildet.

6. Vorrichtung nach einem der Ansprüche 1 bis 5,
**dadurch gekennzeichnet, daß**
das längliche Verbindungsteil (22) eine gabelförmige Ausbildung aufweist, in deren Endteil die Drehführung (44/45) des verschiebbaren Tragelementes (30) gelagert ist.

7. Vorrichtung nach einem der Ansprüche 1 bis 6,
**dadurch gekennzeichnet, daß**
eine optische Detektionseinrichtung (25) aus einem Lichtstrahlen (24) aussendenden Sender (50) und einem via in der inneren, verspiegelten Rückwand (26) der Waferkassette (28) reflektierten Lichtstrahlen aufnehmenden Empfänger (51) besteht, wobei sowohl Sender wie Empfänger auf dem beweglichen Arm (20) der Greifvorrichtung (21) angeordnet sind.

8. Vorrichtung nach Anspruch 7,
**dadurch gekennzeichnet, daß** als Sender (50) eine Laserlichtquelle vorgesehen ist.

## Claims

1. An apparatus for holding and/or transporting platelike substrates, in particular wafers, by means of handling systems in substrate processing and/or inspection appliances, in particular in wafer inspection appliances, wherein a movable arm (20) of the handling system (5) is provided with a gripper means (21), the substrate (31) to be held and transported, respectively, is gripped between at least two supporting elements (29, 30) opposing each other in the plane of said substrate (31), at least one of said supporting elements (29) being arranged in a fixed location and at least one other movably formed supporting element (30) being adapted to be positioned tangentially to the edge of said substrate to be transported, and both the supporting elements (29, 30) being coupled to each other by at least one elongated connecting element (22), wherein said supporting elements (29, 30), in gripping position, are arranged in a manner to project square to the longitudinal extension of the elongated connecting element (22),
**characterized in that**
said elongated connecting element (22) has included therein a twisting guide (44/45) extending parallel to the longitudinal extension thereof, with said movable supporting element (30) being twistable from its resting position to its gripping position and formed to be resiliently supportable against said substrate (31).

2. The apparatus of claim 1, **characterized in that** at least one of said supporting elements (29, 30) is multiple-engaged with contacting points (63, 64) at the edge of said substrate (31) to be transported.

3. The apparatus of either claim 1 or claim 2, **characterized in that** said twisting guide (44/45) is adapted to be actuated via a first piston/cylinder arrangement (41) comprising a piston (46) having a slotted notch (44) extending in an inclined manner to the longitudinal axis thereof and accommodating a guide pin (45), said piston (46) being movable toward said movable supporting element (30) against the force of a notch spring (43).

4. The apparatus of claim 3, **characterized in that** said first piston/cylinder arrangement (41) is in communication with a second cylinder/piston arrangement (60) being displaceable against the force of a clamping spring (61).

5. The apparatus of claim 4, **characterized in that** said first piston/cylinder arrangement (41) and said second piston/cylinder arrangement (60) are combined to form one unit.

6. The apparatus of any of claims 1 to 5, **characterized in that** said elongated connecting element (22) comprises a fork-like shape having an end portion supporting the twisting guide (69) of said movable supporting element (30).

7. An apparatus according to any of claims 1 to 6, **characterized in that** an optical detection device (25) includes an emitter (50) emitting light beams (24) and a receiver (51) receiving light beams reflected via the interior reflector backwall (26) of the wafer cassette (28), both the emitter and the receiver being located on the movable arm (20) of said gripper means (21).

8. The apparatus of claim 7, **characterized in that** the provided emitter (50) is a laser light source.

## Revendications

1. Dispositif pour maintenir et/ou pour transporter des substrats de forme plate, notamment des pastilles, au moyen de systèmes de manipulation dans des appareils d'usinage et/ou d'inspection des substrats, notamment dans des appareils d'inspection de pastilles, un bras mobile (20) du système de manipulation (5) étant pourvu d'un dispositif de préhension (21) et le substrat (31) à maintenir ou à transporter étant serré entre au moins deux éléments porteurs (29, 30) se faisant face dans le plan du substrat (31 ), au moins un (29) des éléments porteurs étant disposé stationnairement et au moins un autre élément porteur (30), conçu à translation, pouvant être appliqué tangentiellement contre le bord du substrat à transporter, et les deux éléments porteurs (29, 30) étant mutuellement reliés par au moins une pièce de liaison oblongue (22), les éléments porteurs (29, 30) étant disposés, en position de préhension, en faisant saillie perpendiculairement au développement longitudinal de la pièce de liaison oblongue (22), **caractérisé en ce qu'**un guidage en rotation (44/45) est prévu dans la pièce de liaison oblongue (22) parallèlement au développement longitudinal de cette dernière, l'élément porteur (30) mobile en translation pouvant être tourné d'une position de repos dans la position de préhension et est conçu pour pouvoir s'appuyer élastiquement contre le substrat (31).

2. Dispositif selon la revendication 1, **caractérisé en ce qu'**au moins un des éléments porteurs (29, 30) s'appuie plusieurs fois, en des points d'application (63, 64), contre le bord du substrat (31) à transporter.

3. Dispositif selon la revendication 1 ou 2, **caractérisé en ce que** le guidage en rotation (44/45) peut être actionné au moyen d'un ensemble cylindre-piston (41), dans lequel un piston (46) présente une rainure à fente (44) s'étendant en oblique par rapport à l'axe longitudinal et dans laquelle est disposé un axe de déviation (45), le piston (46) pouvant être déplacé en direction de l'élément porteur mobile (30) contre la force d'un ressort à rainure (43).

4. Dispositif selon la revendication 3, **caractérisé en ce que** le premier ensemble cylindre-piston (41) est relié à un deuxième ensemble cylindre-piston (60), qui peut être déplacé contre la force d'un ressort de serrage (61).

5. Dispositif selon la revendication 4, **caractérisé en ce que** le premier ensemble cylindre-piston (41) forme une unité avec le deuxième ensemble cylindre-piston (60).

6. Dispositif selon une des revendications 1 à 5, **caractérisé en ce que** la pièce de liaison oblongue (22) présente une configuration fourchue, dans la partie terminale de laquelle est monté le guidage en rotation (69) de l'élément porteur mobile (30).

7. Dispositif selon une des revendications 1 à 6, **caractérisé en ce qu'**un dispositif de détection optique (25) est constitué d'un émetteur (50) émettant des rayons lumineux (24), et d'un récepteur (51) recevant les rayons lumineux réfléchis par la paroi arrière intérieure métallisée (26) de la cassette de pastille (28), tant l'émetteur que le récepteur étant disposés sur le bras mobile (20) du dispositif de préhension (21).

8. Dispositif selon la revendication 7, **caractérisé en ce qu'**une source de lumière laser est prévue comme émetteur (50).
